Europäisches Patentamt

European Patent Office

Office européen des brevets

(11) Veröffentlichungsnummer: **0 260 378 B1**

## (12) EUROPÄISCHE PATENTSCHRIFT

(45) Veröffentlichungstag der Patentschrift: **04.03.92**

(21) Anmeldenummer: **87105796.4**

(22) Anmeldetag: **18.04.87**

(51) Int. Cl.⁵: **H03C 1/00**, H03B 21/00, H04H 5/00, H03C 1/06

(54) **Verfahren zur Modulation.**

(30) Priorität: **19.09.86 DE 3631818**

(43) Veröffentlichungstag der Anmeldung:
**23.03.88 Patentblatt 88/12**

(45) Bekanntmachung des Hinweises auf die
Patenterteilung:
**04.03.92 Patentblatt 92/10**

(84) Benannte Vertragsstaaten:
**CH DE FR GB LI**

(56) Entgegenhaltungen:
**FR-A- 2 266 380**

(73) Patentinhaber: **Licentia Patent-
Verwaltungs-GmbH
Theodor-Stern-Kai 1
W-6000 Frankfurt/Main 70(DE)**

(72) Erfinder: **Erat, August, Dipl.-Ing.
Treuenbrietzener Strasse 19
W-1000 Berlin 26(DE)**

(74) Vertreter: **Schulze, Harald Rudolf, Dipl.-Ing. et
al
Licentia Patent-Verwaltungs-GmbH Theodor-
Stern-Kai 1
W-6000 Frankfurt/Main 70(DE)**

EP 0 260 378 B1

## Beschreibung

Die Erfindung betrifft ein Verfahren zur Modulation gemäß dem Oberbegriff des Patentanspruchs 1.

Ein Modulator für Stereosignale mit Unterdrükkung der Oberwellen ist z.B. aus der Funktionsbeschreibung des Präzisions-Stereo-Meßcoders MSC 2 (Stromlaufplan-230.9314 S) der Firma Rohde & Schwarz bekannt. Bei diesem Modulator wird die zu modulierende Niederfrequenz des linken und rechten Stereokanals in Stufen geschaltet.

Diese Schaltung ist jedoch sehr aufwendig und gegen Toleranzen der Sample- und Hold-Schaltung und insbesondere der Regelstufen empfindlich.

Weiterhin ist aus dem Dokument FR-A-2 266 380 ein Demodulationsverfahren für Stereoempfänger bekannt, bei dem parasitäre Seitenbandsignale benachbarter Stereosender durch einen Demodulationsträger eliminiert werden indem die 3. Oberwelle unterdrückt ist. Der Demodulationsträger ist als mehrstufiges Rechtecksignal aus gegeneinander phasenverschobenen Teil-Rechtecksignalen zusammengesetzt.

Der Erfindung liegt die Aufgabe zugrunde, den Stand der Technik zu verbessern. Insbesondere soll ein Verfahren zur Modulation der im Oberbegriff des Patentanspruchs 1 genannten Art angegeben werden, daß mit möglichst wenig Aufwand, Justierarbeiten und Kosten realisierbar ist.

Die Aufgabe wird bei einem Verfahren der im Oberbegriff des Patentanspruchs 1 genannten Art durch die im kennzeichnenden Teil des Anspruchs 1 genannten Merkmale gelöst. Infolge der Anwendung zweier um 60° versetzter Trägerfrequenzen für zwei Mischer und der Addition der Ausgangssignale der Mischer kompensieren sich in vorteilhafter Weise die ersten bis dritten Oberwellen des modulierten Signals, so daß es nunmehr möglich ist bei Verwendung des erfindungsgemäßen Verfahrens Modulatoren zu bauen, die nur wenig Aufwand ud außerdem wenige Einstellarbeiten erfordern, so daß zur Unterdrückung der höheren Oberwellen lediglich ein einfacher Tiefpaß genügt. Vorteilhafte Weiterbildungen und Ausgestaltungen der Erfindung sind in den Unteransprüchen angegeben. Das Verfahren nach Anspruch 4 gestattet die einfache Erzeugung der für die Modulation erforderlichen um 60° versetzten Trägerfrequenzen mittels billiger im Handel befindlicher digitaler Bausteine.

Die Erfindung wird nun anhand eines Ausführungsbeispiels näher erläutert. Es zeigen im einzelnen:

FIG. 1: Blockschaltbild des Coders;
FIG. 2: ausführliches Schaltbild des Coders;
FIG. 3: Blockschaltbild der Trägerfrequenzen-Erzeugung.

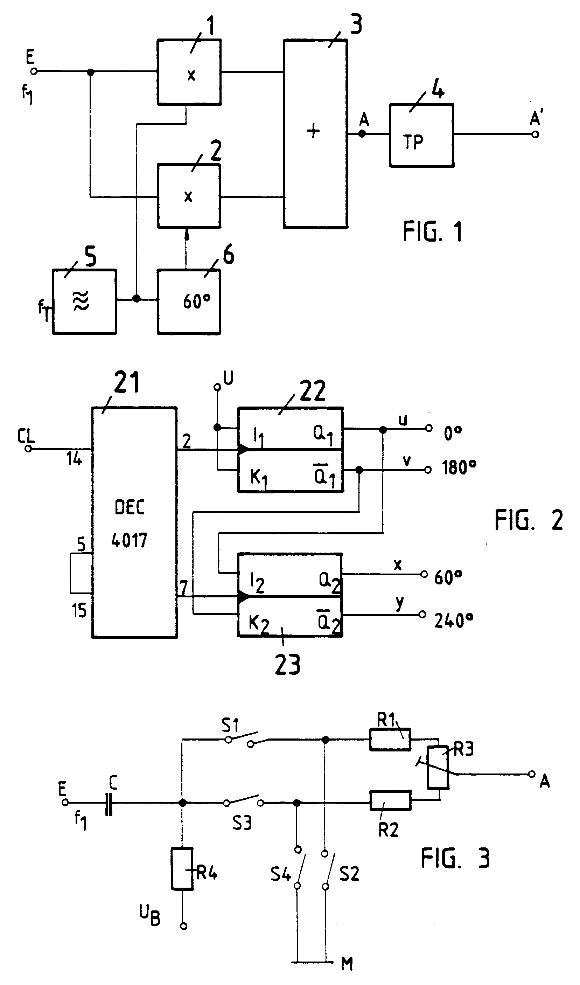

In FIG. 1 ist das Blockschaltbild eines Coders, der zur Anwendung des erfindungsgemäßen Verfahrens geeignet ist, dargestellt. Das zu modulierende Signal mit der ersten Frequenz $f_1$ wird dem Eingang E zugeführt und gelangt von dort an die Eingänge zweier Mischer 1 und 2. Eine Trägerfrequenz $f_T$ wird in einem HF-Generator 5 erzeugt und dem Mischer 1 direkt und dem Mischer 2 über einen Phasenschieber 6 um 60° phasenverschoben zugeführt. Die Ausgangssignale der Mischer 1 und 2 werden in einem Addierer 3 vereint. Am Ausgang A des Addierers 3 kann die mit der Trägerfrequenz $f_T$ modulierte erste Frequenz $f_1$ abgenommen werden. Ein nachgeschalteter Tiefpaß 4 dient zur Unterdrückung unerwünschter Oberwellen.

Infolge der Anwendung zweier um 60° versetzter Trägerfrequenzen für die beiden Mischer 1 und 2 und der Addition der Ausgangssignale der Mischer kompensieren sich die ersten bis dritten Oberwellen. Die Kompensation der Oberwellen bei dem erfindungsgemäßen Verfahren kann wie folgt erklärt werden:
Für die Mischprodukte am Ausgang eines Mischers gilt:

$$f_M = (f_T \pm f_1) + (2 \bullet f_T \pm f_1) + (3 \bullet f_T \pm f_1) + (4 \bullet f_T \pm f_1) + (5 \bullet f_T \pm f_1) + \ldots (n \bullet f_T \pm f_1)$$

mit n = ganze Zahl > 1
Bei Symmetrie der Trägerfrequenz f (positive und negative Halbwellen haben den gleichen zeitlichen Verlauf) heben sich alle Mischprodukte mit geradzahligem n auf. Da dem zweiten Mischer eine um 60° phasenverschobene Trägerfrequenz zugeführt wird, liegen am Eingang des Addiergliedes 3 mit n = 3 die sich bei der Addition auslöschenden Mischfrequenzen

$$+ (3 \bullet f_T \pm f_1) \text{ und } -(3 \bullet f_T \pm f_1).$$

Besonders einfach im Aufbau wird der Coder bei der Verwendung des sogenannten Schalterverfahrens, das insbesondere bei der Aufbereitung eines Stereosignals beim Rundfunk angewendet wird. Bei diesem wird die zu modulierende Frequenz $f_1$ im Takt der als Rechtecksignal gewählten Trägerfrequenz durch elektronische Schalter getaktet. Das Tastverhältnis der Trägerfrequenz soll wegen der Symmetrie möglichst genau 2:1 sein, damit sich im Mischprodukt Glieder mit ganzzahligem n kompensieren.

FIG. 2 zeigt, wie in einfacher Weise die um 60° phasenverschobenen Trägerfrequenzen $f_t$ als Rechtecksignale erzeugt werden können. An den Eingang Cl z.B. eines Dezimaldecoders 21 (z.B. CD 4017), der durch Verbinden seiner Anschlüsse 5 und 15 (Verbindung des Decoderausgangs "6" mit dem Reseteingang) auf eine 6er-Periode umgeschaltet ist, wird eine Taktfrequenz angelegt, die 12mal höher ist als die erforderliche Trägerfrequenz $f_T$. Am Decoderausgang 2 ("1") ist der Takteingang eines Flip-Flops 22 angeschlossen, dessen Eingänge $I_1$ und $K_1$ mit der Betriebsspannung $U_B$ verbunden sind. An seinen beiden Ausgängen $Q_1$ und $\overline{Q_1}$ ist die Trägerfrequenz z.B. in den Phasenlagen $0°$ und $180°$ jeweils als Rechteckspannung u und v abgreifbar.

Die Ausgänge des Flip-Flops 22 sind mit den $I_2$- und $K_2$-Eingängen eines Flip-Flops 23 verbunden, dessen Takteingang an den Decoderausgang 7 ("3") des Decoders 21 angeschlossen ist. An den $Q_2$- und $\overline{Q_2}$-Ausgängen des Flip-Flops 23 sind die Trägerfrequenzen in den Phasenlagen $60°$ bzw. $240°$ abgreifbar. Für die beiden Flip-Flops 22 und 23, die beide bistabile Kippstufen sind, kann z.B. die integrierte Schaltung CD 4027 verwendet werden.

Die Rechteck-Trägerfrequenzen der mit u, v, x und y bezeichneten Ausgangsspannungen der Flip-Flops 22 und 23 sind in den Figuren nicht dargestellten elektronischen Schaltern zugeführt. Als Schaltbaustein kann beispielsweise die integrierte Schaltung CD 4066 verwendet werden.

FIG. 3 zeigt das Prinzipschaltbild eines nach dem Schalterverfahren arbeitenden Coders unter Anwendung des erfindungsgemäßen Verfahrens. Als Mischer 1 und 2 dienen die Schalter S1 und S2 (als Mischer 1) und S3 und S4 (als Mischer 2). Der Schalter S1 wird vom u-Signal (FIG. 2), der Schalter S2 vom v-Signal, der Schalter S3 vom x-Signal und der Schalter S4 vom y-Signal gesteuert. Beispielsweise mittels des oben erwähnten Schaltbausteines CD 4066.

Das zu modulierende Signal der Frequenz $f_1$ am Eingang E ist von der Schaltung dirch einen Kondensator C galvanisch getrennt. Die Schalter S1 und S2 sowie S3 und S4 sind jeweils miteinander verbunden. Die freien Kontakte der Schalter S1 und S3 liegen über einen Kondensator C am Eingang E und über einen Widerstand 4 zusätzlich an einer Betriebsspannung $U_B$. Die freien Kontakte der Schalter S2 und S4 liegen auf Bezugspotential M. Der Verbindungspunkt der Schalter S1 und S2 liegt über einen Widerstand R1 an einem ersten Eingang eines linearen Potentiometers R3 und der Verbindungspunkt der Schalter S3 und S4 über einen Widerstand R2 am anderen Eingang des Potentiometers R3. Die Schaltung der Widerstände R1, R2 in Verbindung mit Potentiometer R3 bilden den in FIG. 1 mit 3 bezeichneten Addierer. Der Abgriff des Potentiometers ist etwa in Mittelstellung eingestellt und zwar so, daß die zweite Oberwelle des Mischproduktes am Ausgang A ein Minimum wird.

Es ergibt sich im Betrieb in vorteilhafter Weise nun folgender Sachverhalt:

Bei einem Tastverhältnis 2:1 der Trägerfrequenz $f_T$ istdie 1. Oberwelle ($2 \bullet f_T \pm f_1$) nicht vorhanden. Infolge des erfindungsgemäßen Verfahrens liegen die 2. Oberwellen ($3 \bullet f_T \pm f_1$) der Mischer am Ausgang in Gegenphase und werden dadurch ausgelöscht.

Die 3. Oberwelle ($4 \bullet f_T \pm f_1$) ist wie die 1. Oberwelle infolge der Symmetrie des Trägerfrequenzsignals nicht vorhanden.

Da erst die 4. Oberwelle ($5 \bullet f_T \pm f_1$) auftritt, sind die Anforderungen an einen Tiefpaß zur Ausfilterung der Oberwellen außerordentlich gering, so daß für den Tiefpaß 4 (siehe FIG. 1) ein preisgünstiger LC-Tiefpaß oder ein aktiver RC-Tiefpaß 3. Ordnung genügt.

## Patentansprüche

1. Verfahren zur Modulation einer ersten Frequenz mit einer Trägerfrequenz, dadurch gekennzeichnet, daß die zu modulierende erste Frequenz ($f_1$) zwei Mischern (1, 2) zugeführt wird, wobei dem zweiten Mischer (2) eine gegenüber der Phase der Trägerfrequenz für den ersten Mischer (1) um $60°$ versetzte Trägerfrequenz zugeführt wird, daß zur Gewinnung der modulierten Frequenz ($f_M$) die Ausgangssignale der Mischer (1, 2) addiert werden und daß die Modulation unter Verwendung des Schalter-Verfahrens erfolgt.

2. Verfahren nach Anpruch 1, dadurch gekennzeichnet, daß zur Realisierung des Schalter-Verfahrens digitale Bausteine verwendet werden.

3. Verfahren nach Anspruch 2, dadurch gekennzeichnet, daß zur Erzeugung der beiden um $60°$ versetzten Trägerfrequenzen ein Dezimal-Decoder (21) verwendet wird, dessen Takteingang ein ganzzahliges Vielfaches der Trägerfrequenz zugeführt wird und dessen Ausgänge periodisch zwei um $60°$ versetzte Impulse entnommen werden, jeweils mit der für die Modulation der ersten Frequenz erforderlichen Trägerfrequenz, daß die Ausgangsimpulse des Dezimal-Decoders jeweils einem Takteingang einer bistabilen Kippstufe (22, 23) zugeführt werden und die zum Schalten beim Schalter-Verfahren erforderlichen Steuerspannungen den Ausgängen ($Q_1$, $\overline{Q_1}$ und $Q_2$, $\overline{Q_2}$) der bistabilen Kippstufen (22, 23) entnommen werden.

## Claims

1. Method for the modulation of a first frequency by a carrier frequency, characterised thereby that the first frequency (f1), which is to be modulated, is fed to two mixers (1, 2), wherein a carrier frequency, which is shifted by 60° relative to the phase of the carrier frequency for the first mixer (1), is fed to the second mixer (2), that the output signals of the mixers (1, 2) are added for obtaining of the modulated frequency (fm) and that the modulation takes place with use of the switch process.

2. Method according to claim 1, characterised thereby that digital blocks are used for the realisation of the switch process.

3. Method according to claim 2, characterised thereby that for the generation of the two carrier frequencies shifted by 60° there is used a decimal decoder (21) to the pulse input of which is fed an integral multiple of the carrier frequency and at the outputs of which two pulses shifted by 60° are periodically derived each with the carrier frequency required for the modulation of the first frequency, that the output pulses of the decimal decoder are each fed to a pulse input of a respective bistable trigger stage (22, 23) and the control voltages required for the switching in the switch process are derived from the outputs (Q1,$\overline{Q1}$ and Q2, $\overline{Q2}$) of the bistable trigger stages (22, 23).

**Revendications**

1. Procédé de modulation d'une première fréquence avec une fréquence porteuse, caractérisé en ce que la première fréquence à moduler ($f_1$) est injectée à deux mélangeurs (1, 2), le second mélangeur (2) recevant une fréquence porteuse déphasée de 60° par rapport à celle injectée au premier mélangeur (1), en ce que, pour obtenir la fréquence modulée ($f_M$), les signaux de sortie des mélangeurs (1, 2) sont additionnés et en ce que l'on effectue la modulation à l'aide du procédé de commutation.

2. Procédé selon la revendication 1, caractérisé en ce que l'on utilise des composants numériques pour mettre en oeuvre le procédé de commutation.

3. Procédé selon la revendication 2, caractérisé en ce que, pour générer les deux fréquences porteuses déphasées de 60°, on utilise un décodeur décimal (21) dont l'entrée de rythme reçoit un multiple entier de la fréquence porteuse et dont les sorties fournissent périodiquement deux impulsions décalées de 60°, chacune avec la fréquence porteuse nécessaire pour la modulation de la première fréquence, en ce que les impulsions de sortie du décodeur décimal sont envoyées à l'entrée de rythme d'une bascule bistable (22, 23) dont les sorties ($Q_1$' /$Q_1$ et $Q_2$ /$Q_2$) fournissent les tensions de commande nécessaires pour la commutation, dans le procédé de commutation.

FIG. 1

FIG. 2

FIG. 3